# EUROPEAN PATENT SPECIFICATION

(11) **EP 1 139 401 B1**
(45) Date of publication and mention of the grant of the patent: **07.01.2015**
(21) Application number: 99973167.2
(22) Date of filing: 26.11.1999
(51) Int. Cl.: G03F 7/42, H01L 21/3213, C11D 7/08, C11D 11/00

(54) **COMPOSITION FOR REMOVING SIDEWALL AND METHOD OF REMOVING SIDEWALL**
ZUSAMMENSETZUNG UND VERFAHREN ZUR SEITENWANDENTFERNUNG
COMPOSITION ET PROCEDE POUR ELIMINER DES CHANTS

(30) Priority: 27.11.1998 JP 33759498; 06.07.1999 JP 19229099; 09.09.1999 US 152956 P
(43) Date of publication of application: 04.10.2001
(73) Proprietor: SHOWA DENKO K.K., Tokyo 105-8518 (JP)
(72) Inventor: OGATA, Fujimaro, Shunan-shi, YAMAGUCHI 746-0006 (JP); SUGIYAMA, Tsutomu, Shunan-shi, YAMAGUCHI 746-0006 (JP); MIYAHARA, Kuniaki, Shunan-shi, YAMAGUCHI 746-0006 (JP)
(74) Representative: Strehl Schübel-Hopf & Partner
(86) International application number: PCT/JP1999/006603
(87) International publication number: WO 2000/033371

(56) References cited:
- EP-A2- 0 678 571
- EP-A2- 0 680 078
- EP-A2- 0 827 188
- WO-A-97/03175
- JP-A- 07 201 793
- JP-A- 07 249 607
- JP-A- 11 233 405
- JP-A- H07 249 607
- US-A- 2 736 639

## Description

### TECHNICAL FIELD

The present invention relates to the use of a composition for removing side wall, which can remove a side wall deposit (side wall) containing resist polymer and inorganic substances, generated at dry etching using halogen-type gas in the production process of a semiconductor, at a low temperature within a short time while not corroding the wiring material.

### BACKGROUND ART

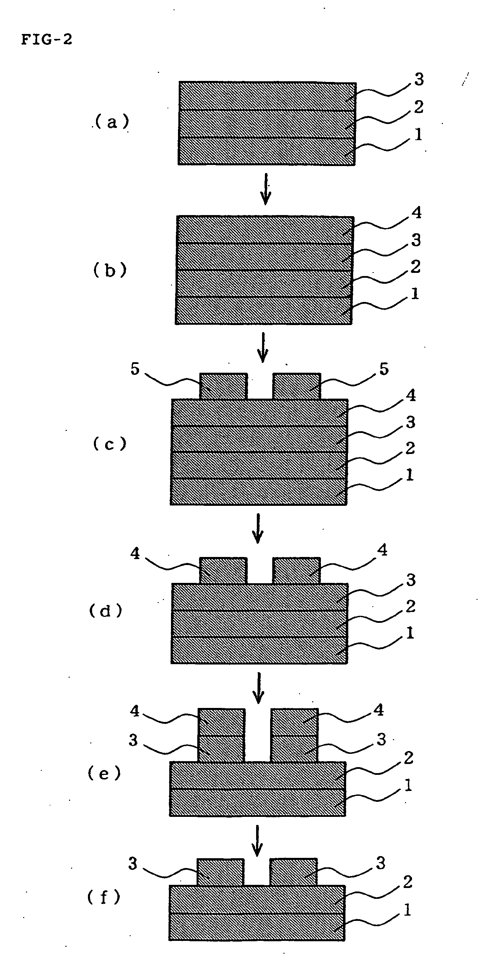

A semiconductor device is conventionally produced using a photoresist resin as shown in Fig.2 (a) to (f), for example, through the following steps (1) to (6):
(1) a metal layer which works out to a wiring material, such as Al, is formed on an insulating layer such as SiO₂ on a substrate 1 (Fig.2 (a));
(2) a positive photoresist 4 is formed on the metal layer 3 (Fig.2 (b));
(3) a photomask 5 is superposed thereon and the photoresist layer is exposed (Fig.2 (c));
(4) the photoresist layer is developed to form a resist pattern (Fig.2 (d));
(5) the exposed metal layer is etched (Fig.2(e)); and
(6) the resist pattern is stripped and removed to obtain a metal wiring pattern (Fig.2 (f))

To keep up with the tendency in recent years toward higher density of the integrated circuit, formation of a finer pattern is necessary. In the etching step, wet etching by using chemicals has heretofore predetermined, but wet etching is not appropriate for forming a finer pattern because etching direction is not oriented. For forming a finer pattern, dry etching, especially dry etching by using a halogen-type gas such as chlorine gas or BCl₃ which is capable of anisotropic etching is taking the place of it.

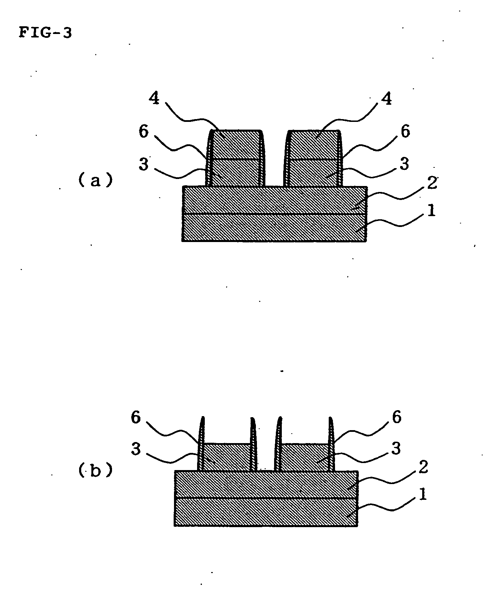

In the dry etching, film comprising resist polymer and inorganic substances is formed on the side of metal and resist pattern on the metal as shown in Fig.3 (a). The remained film is called side wall, and the side surface is protected by this side wall therefore, anisotropic etching can be used. The side wall is produced by the chemical reaction of photoresist, wiring material and etching gas at the dry etching. As a result, the side wall assumes a compound having a complicated composition comprising an organic material derived from the photoresist, an inorganic material derived from the wiring material and a halide derived from etching gas.

In the dry etching, in order to completely remove the remained photoresist, an ashing operation (ashing) where the remained photoresist is burned with oxygen plasma after dry etching step, is conducted, but the side wall is not completely removed and a part of it remained (Fig.3(b)). In the side wall, halogen radical or halogen ion generated at the dry eching with a halogen-type gas is imprisoned and on contacting with water in air, generates an acid. The acid generated corrodes the wiring material (after-corrosion). Because of this, the side wall must be completely removed.

The stripping solution is originally designed to strip the photoresist which is an organic material, therefore, it cannot satisfactorily strip and remove the above-described side wall.

For example, an acidic stripping solution of alkylbenzene-sulufonic acid type cannot satisfactorily remove the side wall even under heating at a high temperature of 100 °C. Moreover, the acidic stripping solution has low solubility in water and must be rinsed with a water-soluble organic solvent such as IPA before water rinsing, as a result, the process is complicated.

An alkaline stripping solution of organic amine type also has difficulties in removing the side wall even under heating at a high temperature of 100 °C. Furthermore, if the resulting substrate is immediately rinsed with water, the organic amine component and water interact to present strong alkalinity and corrosion of the wiring material is generated. Accordingly, the substrate must be rinsed with IPA or the like in advance of water rinsing, as a result, the process is complicated.

US patent 5308745 (JP-A-6-202345) proposes a stripping composition for highly crosslinked or cured photoresist comprising a stripping solvent such as 2-pyrrolidinone, an amine and a weak acid, and JP-A-7-219240 proposes a positive resist-stripping solution obtained by blending a carboxyl group-containing organic compound with a resist-stripping compositon comprising a nitrogen-containing organic hydroxyl compound. However, as described above, the resist-stripping solution cannot satisfactorily remove the side wall. Furthermore, although an acid such as hydrochloric acid and sulfuric acid, or a base such as aqueous alkylamine and alkanolamine solution may remove the side wall by dissolving the aluminum as a wiring material, they indispensably corrode the wiring material.

Under these circumstances, the use of a stripping solution capable of easily removing a side wall produced by anisotropic dry etching after the formation of photoresist without corroding the wiring material is demanded. The side wall is produced as a result of chemical reaction of photoresist, wiring material and etching gas and assumes a compound having a complicated composition comprising an organic material derived from photoresist, an inorganic material derived from wiring material and a halide derived from etching gas.

### DISCLOSURE OF THE INVENTION

The object of the present invention is to provide the use of a composition for removing side wall capable of removing a side wall at low temperature within a short time while not corroding the wiring material.

As a result of extensive investigations, the present inventors have found that side wall can be removed at low temperature within a short time while not corroding the wiring material by use of a liquid composition comprising nitric acid which by itself corrodes the wiring material, and a polycarboxylic acid and an aminocarboxylic acid. The present invention has been accomplished based on this finding.

The present invention provides the following.
[1] The use of an aqueous solution
   (i) consisting of water, nitric acid, at least one kind of carboxylic acids selected from polycarboxylic acid and aminocarboxylic acid, or
   (ii) consisting of water, nitric acid, at least one kind of carboxylic acids selected from polycarboxylic acid and aminocarboxylic acid, and a surfactant,
   for removing a sidewall deposit containing resist polymer and inorganic substances generated by dry etching using halogen type gas in the production of a semiconductor, while not corroding the wiring material, wherein the nitric acid has an oxidizing action,
   wherein said polycarboxylic acid is at least one selected from the group consisting of citric acid, tartaric acid, malic acid, succinic acid, maleic acid, oxalic acid, malonic acid, glutanic acid, adipic acid, D-glucanic acid, itaconic acid, citraconic acid, mesaconic acid, 2-oxoglutaric acid, 3-oxoglutaric acid, acetylenedicarboxylic acid, 1,1-cyclopropanedicarboxylic acid, trimellitic acid, endothal, glutamic acid, methylsuccinic acid and citramalic acid, and
   said aminocarboxylic acid is at least one selected from glycine, alanine, β-alanine, 2-amino-butyric acid, 3-amino-butyric acid, 4-amino-butyric acid, 2-aminocapronic acid and 6-aminocapronic acid,
   wherein the concentration of said nitric acid is from 0.1 to 50 mass%,
   the concentration of said carboxylic acids is from 0.1 to 30 mass%,
   wherein the cleaning treatment is operated within a temperature of 0 to 80 °C, and
   wherein the cleaning treatment is operated within a period of 1 to 60 minutes.
[2] The use as described in [1] above, wherein said polycarboxylic acid is citric acid.
[3] The use as described in [1] above, wherein said aminocarboxylic acid is glycine.
[4] The use as described in [1] above, wherein the carboxylic acids are polycarboxylic acid and aminocarboxylic acid.
[5] The use as described in [4], wherein polycarboxylic acid is citric acid and aminocarboxylic acid is glycine.
[6] The use of any of the preceding items [1] to [5] above, wherein the cleaning treatment is made by dipping.
[7] The use of any of the preceding items, wherein the cleaning treatment is operated within a temperature of 10 to 60 °C.
[8] The use of any of the preceding items, wherein the cleaning treatment is operated within a period of 1 to 30 minutes.
[9] The use of any of the preceding items, wherein the semiconductor device has Al alloy wiring.

### BRIEF DESCRIPTION OF THE DRAWING

Fig.1 (a) ~ (e) is an explanatory view showing the process of producing semiconductor devices.
Fig.2 (a) ~ (f) is an explanatory view showing the process of producing semiconductor devices using photoresist resin.
Fig.3 (a) and (b) is an explanatory view showing the process of dry etching using halogen-type gas and ashing treatment after etching.

### EMBODIMENT OF THE INVENTION

The present invention is described in detail below.

The composition for removing side wall used in the present invention is usually provided as an aqueous solution containing nitric acid and at least one of polycarboxylic acid and amino carboxylic acid.

The nitric acid mainly acts as an effective component for removing a side wall. The concentration of nitric acid is from 0.1 to 50 mass% based on the composition as a whole. If the nitric acid concentration is less than this range, the side wall cannot be removed completely, whereas even if the nitric acid concentration exceeds the range, the effect does not increase any more.

The polycarboxylic acid and an aminocarboxylic acid (hereinafter referred to as "carboxylic acids") mainly acts as an effective component for preventing the corrosion of wiring material. The concentration of carboxylic acids is preferably from 0.1 to 30 mass% based on the composition as a whole. If the concentration of carboxylic acids is less than this range, the corrosion of wiring material cannot be prevented, whereas even if it exceeds the range, the effect does not increase any more.

Examples of the polycarboxylic acid which can be used in the present invention include citric acid, tartaric acid, malic acid, succinic acid, maleic acid, oxalic acid, malonic acid, glutanic acid, adipic acid, D-glucanic acid, itaconic acid, citraconic acid, mesaconic acid, 2-oxoglutaric acid, 3-oxoglutaric acid, acetylenedicarboxylic acid, 1,1-cyclopropanedicarboxylic acid, trimellitic acid, endothal, glutamic acid, methylsuccinic acid, and citramalic. Citric acid among them is preferably used, however, the present invention is by no means limited thereto. These carboxylic acids may be used either individually or in combination of two or more thereof.

Example of the aminocarboxylic acid which can be used in the present invention include glycine, alanine, β-alanine, 2-aminobutyric acid, 3-aminobutyric acid, 4-aminobutyric acid, 2-aminocaproic acid, and 6-aminocaproic acid. Glycine is preferably used, however, the present invention is by no means limited thereto. These aminocarboxylic acids and aminocarboxylates may be used either individually or in combination of two or more thereof.

The composition used in the present invention can be added with a surfactant in a small amount.

Although the mechanism that the composition used in the present invention comprising nitric acid and acids described above can remove side wall as well as prevent corrosion of metal wiring is not clear, it is thought that nitric acid and acids dissolve a very slight amount of metal component of the wiring material and strip off the side wall outside the metal, and at the same time a non-conductor film is formed on the metal surface of wiring material by the oxidizing action of nitric acid or an anticorrosive film was formed on the metal surface by the chelating effect of the carboxylic acids.

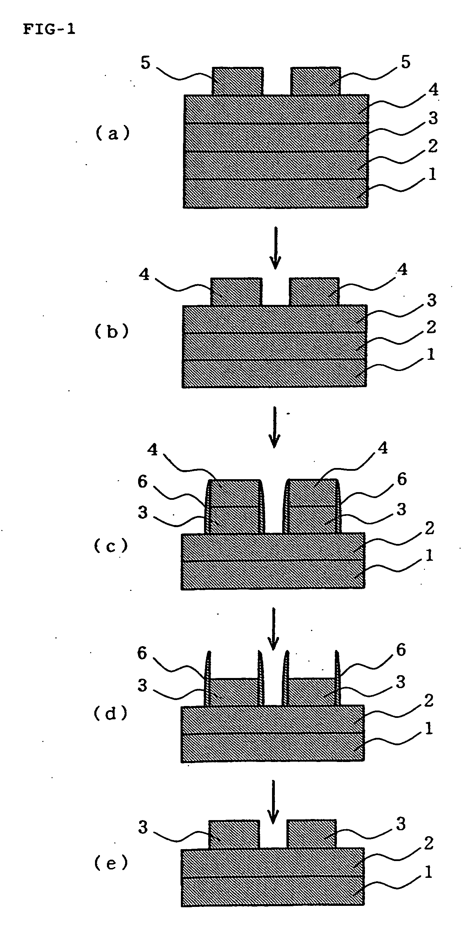

An example of process for producing semiconductor devices containing the step of removing side wall according to the claims, is explained hereinafter in reference to Fig.1 (a) to Fig.1 (e).

Fig.1 (a) is a view showing the process of forming an insulating layer 2 such as SiO₂ on a substrate (for example silicon) 1, forming a metal layer 3 such as Al alloy (Al-Cu, etc.) working out to a wiring material on the insulating layer, forming a positive photoresist layer 4 on the metal layer, superposing a photomask 5 on the photoresist layer, and exposing the photoresist layer. The area exposed to the light becomes soluble in an alkali aqueous solution developer.

Fig.1 (b) is a view showing the process of developing the photoresist layer to form a resist pattern. The resist in the area exposed to the light is removed.

Fig.1 (c) is a view showing the process of dry etching the exposed metal layer 3 using halogen-type gas (chlorine-type gas, BCl₃ gas, etc.) by an ordinary method. The metal layer 3 in the area where the resist has been removed, is etched and at the same time side wall 6 is formed. The side wall 6 plays a role of protecting the remaining metal layer 3 from excessive etching.

Fig.1 (d) is a view showing the step of removing the resist pattern 4 by oxygen plasma ashing to obtain a metal wiring pattern 3.

Fig.1 (e) is a view showing the process of removing the side wall 6 by the inventive use of the composition for removing side wall. By using this composition for removing side wall, the side wall 6 can be removed at a low temperature within a short time while not corroding the wiring material.

Composition for removing side wall can be applied for the resist such as positive resist (novolak-type photoresist) comprising phenolformaldehyde resin or poly(p-vinylphenol); resist comprising polymethylmethacrylate.

The cleaning treatment of the present invention by the composition for removing side wall is ordinarily made by dipping method, but other method such as spraying method can be also applied.

The conditions for the cleaning treatment by dipping method vary depending on the concentration of nitric acid and the kind of carboxylic acid to be added. But generally the temperature of the cleaning treatment is from 0 to 80 °C, preferably from 10 to 60 °C and the time of cleaning treatment is from 1 to 60 minutes, preferably from 1 to 30 minutes.

Semiconductor device after removing the side wall by the cleaning treatment only needs rinsing with water, and does not need to be treated with any organic solvent such as an alcohol.

### BEST MODE FOR CARRYING OUT THE INVENTION

The present invention is described below by referring to Examples and Comparative Examples.

### Examples 1 to 26

On a silicon wafer substrate, SiO₂ film was formed and further thereon, Al-Cu layer was formed. On the Al-Cu layer, a novolak type photoresist is coated, exposed and developed to form a resist pattern. Thereafter, the metal layer was dry etched with a chlorine-type gas and the resist except for the side wall was removed by ashing to obtain a test substrate.

The substrate obtained above was dipped in a composition for removing side wall of the present invention having a composition shown in Table 1 and 2, containing nitric acid and an organic acid at predetermined temperature and for predetermined time, rinsed with water and dried. Then removability of the side wall and corrosiveness of the wiring material were evaluated according to the criteria specified below, by observing the surface of the treated substrate through SEM(scanning electron microscope). The results obtained are shown in Table 1 and 2.

| | |
|---|---|
| Removability: | ○: The side wall was completely removed. |
| | ×: The side wall was not removed. |
| Corrosiveness: | ○: The wiring material was not corroded. |
| | ×: The wiring material was corroded. |

**Table 1**

| Example | Nitiric Acid Concent -ration (mass%) | Organic acid (mass%) | Dipping Time (min) | Dipping Temperature (°C) | Removability | Corrosiveness |
|---|---|---|---|---|---|---|
| 1 | 1 | citric acid, 0.01 | 20 | 50 | ○ | ○ |
| 2 | 1 | tartaric acid, 0.01 | 20 | 50 | ○ | ○ |
| 3 | 1 | malic acid, 0.01 | 20 | 50 | ○ | ○ |
| 4 | 1 | succinic acid, 0.01 | 20 | 50 | ○ | ○ |
| 5 | 1 | maleic acid, 0.01 | 20 | 50 | ○ | ○ |
| 6 | 1 | oxalic acid, 0.01 | 20 | 50 | ○ | ○ |
| 7 | 30 | citric acid, 3.0 | 20 | 50 | ○ | ○ |
| 8 | 30 | tartaric acid, 3.0 | 20 | 50 | ○ | ○ |
| 9 | 30 | malic acid, 3.0 | 20 | 50 | ○ | ○ |
| 10 | 30 | succinic acid, 3.0 | 20 | 50 | ○ | ○ |
| 11 | 30 | maleic acid, 3.0 | 20 | 50 | ○ | ○ |
| 12 | 30 | oxalic acid, 3.0 | 20 | 50 | ○ | ○ |
| 13* | 1 | ammonium citrate, 0.02 | 20 | 50 | ○ | ○ |
| 14* | 1 | ammonium malate, 0.02 | 20 | 50 | ○ | ○ |
| 15* | 30 | ammonium citrate, 5.0 | 20 | 50 | ○ | ○ |
| 16* | 30 | ammonium malate, 5.0 | 20 | 50 | ○ | ○ |
| 17 | 1 | glycine, 0.1 | 20 | 50 | ○ | ○ |
| 18 | 1 | alanine, 0.1 | 20 | 50 | ○ | ○ |
| 19 | 1 | 2-amino-butyric acid, 0.1 | 20 | 50 | ○ | ○ |
| 20 | 15 | glycine, 5.0 | 20 | 50 | ○ | ○ |
| 21 | 15 | alanine, 5.0 | 20 | 50 | ○ | ○ |
| 22 | 15 | 2-amino-butyric acid, 5.0 | 20 | 50 | ○ | ○ |
| 23* | 1 | glycine ammonium, 0.2 | 20 | 50 | ○ | ○ |
| 24* | 1 | alanine ammonium, 0.2 | 20 | 50 | ○ | ○ |

| | | | | | | |
|---|---|---|---|---|---|---|
| *not belonging to the scope of the invention | | | | | | |

**Table 2**

| Example | Nitric Acid Concentration, (mass%) | Citric Acid Concentration, (mass%) | Glycine Concentration, (mass%) | Dipping Time (min) | Dipping Temperature (°C) | Removability | Corrosiveness |
|---|---|---|---|---|---|---|---|
| 25 | 30 | 1 | 5 | 5 | 50 | ○ | ○ |
| 26 | 30 | 3 | 5 | 5 | 50 | ○ | ○ |

### Comparative Examples 1 to 3:

The substrate described in the above examples was dipped in an aqueous solution containing nitric acid having concentration shown in Table 3 at predetermined temperature and for predetermined time, rinsed with water and dried. Then removability of the side wall and corrosiveness of the wiring material was evaluated in a condition same as examples, by observing it through SEM(scanning electron microscope). The results obtained are shown in Table 3.

**Table 3**

| Comparative Example | Nitric Acid Concentration, (mass%) | Concentration of additive, (mass%) | Dipping Time (min) | Dipping Temperature (°C) | Removability | Corrosiveness |
|---|---|---|---|---|---|---|
| 1 | 1 | 0 | 20 | 50 | ○ | × |
| 2 | 15 | 0 | 10 | 50 | ○ | × |
| 3 | 30 | 0 | 5 | 50 | ○ | × |

It is seen from Tables 1 and 2 that by using a composition for removing side wall according to the present invention, which comprises an aqueous solution containing both nitric acid and a polycarboxylic acids and an aminocarboxylic acids (Examples 1 to 12, 17 to 22, 25, and 26), the side wall can be removed at a low temperature within a short time while not causing corrosion of the wiring material. On the other hand, when an aqueous solution containing only nitric acid was used, the side wall was removed but the wiring material was corroded (Table 3).

### INDUSTRIAL APPLICABILITY

By using the composition for removing side wall of the present invention which comprises both nitric acid and at least one kind of carboxylic acids selected from the group consisting of polycarboxylic acid and aminocarboxylic acid, the side wall can be removed at a low temperature within a short time while not causing corrosion of the wiring material.

By using the composition for removing side wall of the present invention, semiconductor device provided with metal wiring such as Al alloy which is not substantially corroded can be obtained.

According to the use of the composition of the present invention, semiconductor device after cleaning treatment can be rinsed with water, and the solvent for rinsing such as alcohol does not need to be used.

The use of the composition of the present invention does not have any adverse effect on human body and environment.

## Claims

1. The use of an aqueous solution
(i) consisting of water, nitric acid, at least one kind of carboxylic acids selected from polycarboxylic acid and aminocarboxylic acid, or
(ii) consisting of water, nitric acid, at least one kind of carboxylic acids selected from polycarboxylic acid and aminocarboxylic acid, and a surfactant,
for removing a sidewall deposit containing resist polymer and inorganic substances generated by dry etching wiring using halogen type gas in the production of a semiconductor, while not corroding the wiring material, wherein the nitric acid has an oxidizing action,
wherein said polycarboxylic acid is at least one selected from the group consisting of citric acid, tartaric acid, malic acid, succinic acid, maleic acid, oxalic acid, malonic acid, glutanic acid, adipic acid, D-glucanic acid, itaconic acid, citraconic acid, mesaconic acid, 2-oxoglutaric acid, 3-oxoglutaric acid, acetylenedicarboxylic acid, 1,1-cyclopropanedicarboxylic acid, trimellitic acid, endothal, glutamic acid, methylsuccinic acid and citramalic acid, and
said aminocarboxylic acid is at least one selected from glycine, alanine, β-alanine, 2-amino-butyric acid, 3-amino-butyric acid, 4-amino-butyric acid, 2-aminocapronic acid and 6-aminocapronic acid,
wherein the concentration of said nitric acid is from 0.1 to 50 mass%,
the concentration of said carboxylic acids is from 0.1 to 30 mass%,
wherein the cleaning treatment is operated within a temperature of 0 to 80 °C, and
wherein the cleaning treatment is operated within a period of 1 to 60 minutes.

2. The use as claimed in claim 1, wherein said polycarboxylic acid is citric acid.

3. The use as claimed in claim 1, wherein said aminocarboxylic acid is glycine.

4. The use as claimed in claim 1, wherein the carboxylic acids are polycarboxylic acid and aminocarboxylic acid.

5. The use as claimed in claim 4, wherein polycarboxylic acid is citric acid and aminocarboxylic acid is glycine.

6. The use of any of the preceding claims, wherein the cleaning treatment is made by dipping.

7. The use of any of the preceding claims, wherein the cleaning treatment is operated within a temperature of 10 to 60 °C.

8. The use of any of the preceding claims, wherein the cleaning treatment is operated within a period of 1 to 30 minutes.

9. The use of any of the preceding claims, wherein the semiconductor device has Al alloy wiring.

## Patentansprüche

1. Verwendung einer wässrigen Lösung
(i) bestehend aus Wasser, Salpetersäure, mindestens einer unter Polycarbonsäure und Aminocarbonsäure ausgewählten Art einer Carbonsäure, oder
(ii) bestehend aus Wasser, Salpetersäure, mindestens einer unter Polycarbonsäure und Aminocarbonsäure ausgewählten Art einer Carbonsäure und einem oberflächenaktiven Mittel,
zum Entfernen von Seitenwandablagerungen, die Resistpolymer und durch Trockenätzen einer Verdrahtung unter Einsatz eines Gases vom Halogentyp bei der Herstellung eines Halbleiters erzeugte anorganische Substanzen enthält, während das Verdrahtungsmaterial nicht korrodiert, wobei die Salpetersäure eine oxidierende Wirkung hat, wobei die Polycarbonsäure mindestens eine ist, die aus der Gruppe ausgewählt ist, die aus Zitronensäure, Weinsäure, Äpfelsäure, Bernsteinsäure, Maleinsäure, Oxalsäure, Malonsäure, Glutansäure, Adipinsäure, D-Glucansäure, Itaconsäure, Citraconsäure, Mesaconsäure, 2-Oxoglutarsäure, 3-Oxoglutarsäure, Acetylendicarbonsäure, 1,1-Cyclopropandicarbonsäure, Trimellitsäure, Endothal, Glutaminsäure, Methylbernsteinsäure und Citraäpfelsäure besteht, und
die Aminocarbonsäure mindestens eine ist, die unter Glycin, Alanin, β-Alanin, 2-Aminobuttersäure, 3-Amino-Buttersäure, 4-Amino-Buttersäure, 2-Aminocapronsäure und 6-Aminocapronsäure ausgewählt ist,
wobei die Konzentration der Salpetersäure 0,1 bis 50 Massen-% ist,
die Konzentration der Carbonsäuren 0,1 bis 30 Massen-% ist,
wobei die Reinigungsbehandlung innerhalb eines Temperaturbereichs von 0 bis 80°C durchgeführt wird und
wobei die Reinigungsbehandlung während eines Zeitraums von 1 bis 60 Minuten durchgeführt wird.

2. Verwendung nach Anspruch 1, wobei die Polycarbonsäure Zitronensäure ist.

3. Verwendung nach Anspruch 1, wobei die Aminocarbonsäure Glycin ist.

4. Verwendung nach Anspruch 1, wobei die Carbonsäuren Polycarbonsäure und Aminocarbonsäure sind.

5. Verwendung nach Anspruch 4, wobei die Polycarbonsäure Zitronensäure und Aminocarbonsäure Glycin ist.

6. Verwendung nach einem der vorstehenden Ansprüche, wobei die Reinigungsbehandlung durch Eintauchen durchgeführt wird.

7. Verwendung nach einem der vorstehenden Ansprüche, wobei die Reinigungsbehandlung innerhalb eines Temperaturbereichs von 10 bis 60°C durchgeführt wird.

8. Verwendung nach einem der vorstehenden Ansprüche, wobei die Reinigungsbehandlung während eines Zeitraums im Bereich von 1 bis 30 Minuten durchgeführt wird.

9. Verwendung nach einem der vorstehenden Ansprüche, wobei die Halbleitervorrichtung eine Aluminiumlegierungsverdrahtung aufweist.

## Revendications

1. Utilisation d'une solution aqueuse
(i) constituée d'eau, d'acide nitrique, d'au moins un type d'acides carboxyliques choisis parmi un acide polycarboxylique et un acide aminocarboxylique, ou
(ii) constituée d'eau, d'acide nitrique, d'au moins un type d'acides carboxyliques choisis parmi un acide polycarboxylique et un acide aminocarboxylique, et d'un tensioactif,
pour éliminer un dépôt de paroi latérale contenant un polymère de réserve et des substances inorganiques générées par un câblage par gravure sèche utilisant un gaz de type halogéné dans la production d'un semi-conducteur, sans corroder le matériau de câblage, dans laquelle l'acide nitrique a une action oxydante,
dans laquelle ledit acide polycarboxylique est au moins l'un du groupe constitué par l'acide citrique, l'acide tartrique, l'acide malique, l'acide succinique, l'acide maléique, l'acide oxalique, l'acide malonique, l'acide glutanique, l'acide adipique, l'acide D-glucanique, l'acide itaconique, l'acide citraconique, l'acide mésaconique, l'acide 2-oxoglutarique, l'acide 3-oxoglutarique, l'acide acétylènedicarboxylique, l'acide 1,1-cyclopropanedicarboxylique, l'acide trimellitique, l'endothal, l'acide glutamique, l'acide méthylsuccinique et l'acide citramalique, et
ledit acide aminocarboxylique est au moins l'un du groupe constitué par la glycine, l'alanine, la β-alanine, l'acide 2-aminobutyrique, l'acide 3-aminobutyrique, l'acide 4-aminobutyrique, l'acide 2-aminocapronique et l'acide 6-aminocapronique,
dans laquelle la concentration dudit acide nitrique est de 0,1 à 50 % en masse,
la concentration desdits acides carboxyliques est de 0,1 à 30 % en masse, dans laquelle le traitement de nettoyage est effectué à une température de 0 à 80°C, et
dans laquelle le traitement de nettoyage est effectué sur une période de 1 à 60 minutes.

2. Utilisation selon la revendication 1, dans laquelle ledit acide polycarboxylique est l'acide citrique.

3. Utilisation selon la revendication 1, dans laquelle ledit acide aminocarboxylique est la glycine.

4. Utilisation selon la revendication 1, dans laquelle les acides carboxyliques sont un acide polycarboxylique et un acide aminocarboxylique.

5. Utilisation selon la revendication 4, dans laquelle l'acide polycarboxylique est l'acide citrique et l'acide aminocarboxylique est la glycine.

6. Utilisation selon l'une quelconque des revendications précédentes, dans laquelle le traitement de nettoyage est effectué par immersion.

7. Utilisation selon l'une quelconque des revendications précédentes, dans laquelle le traitement de nettoyage est effectué à une température de 10 à 60°C.

8. Utilisation selon l'une quelconque des revendications précédentes, dans laquelle le traitement de nettoyage est effectué sur une période de 1 à 30 minutes.

9. Utilisation selon l'une quelconque des revendications précédentes, dans laquelle le dispositif semi-conducteur a un câblage en alliage d'Al.
